# EUROPEAN PATENT APPLICATION

(11) **EP 3 454 378 A1**
(43) Date of publication of application: **13.03.2019**
(21) Application number: 17190060.8
(22) Date of filing: 08.09.2017
(51) Int. Cl.: H01L 29/786, H01L 29/66

(54) **A METHOD FOR FORMING A VERTICAL CHANNEL DEVICE, AND A VERTICAL CHANNEL DEVICE**

(71) Applicant: IMEC vzw, 3001 Leuven (BE)
(72) Inventor: VELOSO, Anabela, 3001 Leuven (BE); ENEMAN, Geert, 3001 Leuven (BE); COLLAERT, Nadine, 3001 Leuven (BE); ROSSEEL, Erik, 3001 Leuven (BE)
(74) Representative: AWA Sweden AB

(57) **Abstract**

According to an aspect of the present inventive concept there is provided method for forming a vertical channel device, the method comprising:
forming on a substrate (101) a vertical semiconductor pillar (108) including a first pillar section (110), a second pillar section (120) and a third pillar section (130), wherein the second pillar section (120) is arranged between the first pillar section (110) and the third pillar section (130) and wherein the second pillar section (120) is formed of a material being different from a material forming an upper portion (110a) of the first pillar section (110) and different from a material forming a lower portion (130a) of the third pillar section (130),
forming a spacer layer (112, 132) on a peripheral surface of the upper portion (110a) of the first pillar section (110) and on a peripheral surface (130aa) of the lower portion (130a) of the third pillar section (130), and
forming a gate stack (150) embedding the second pillar section (120) and said upper portion (110a) and said lower portion (130a), wherein the spacer layer (112, 132) forms a spacer between the gate stack (150) and said upper portion (110a) and between the gate stack (150) and said lower portion (130a).

## Description

### Technical field

The present inventive concept relates to a method for forming a vertical channel device, as well as a vertical channel device.

### Background

Driven by the desire to produce even more power efficient semiconductor devices and area efficient circuit designs, new semiconductor devices are being developed. One promising type of devices are vertical channel transistor devices. A vertical channel transistor device may include a vertically oriented semiconductor pillar and a gate wrapping-around the pillar. One example of a vertical channel transistor device is the gate-all-around field effect transistor (GAAFET).

For horizontal or 2d-layout devices, such as planar FETs, finFETs or horizontal GAAFETs, there are processes for fabricating devices having source/drain (S/D) regions being self-aligned to the gate. For vertical channel devices such self-alignment may however be difficult to achieve. This is due to the vertical orientation of the channel, wherein the active channel region and the gate length is not defined by a linewidth but rather by the vertical position and dimension of the gate. Precise control of the vertical position of the gate is however challenging to achieve.

### Summary

An objective of the present inventive concept is to provide a method which enables an improved control of the vertical position of the gate, and thus of the definition of the active channel region.

According to a first aspect of the present inventive concept there is provided a method for forming a vertical channel device, the method comprising:
forming on a substrate a vertical semiconductor pillar including a first pillar section, a second pillar section and a third pillar section, wherein the second pillar section is arranged between the first pillar section and the third pillar section and wherein the second pillar section is formed of a material being different from a material forming an upper portion of the first pillar section and different from a material forming a lower portion of the third pillar section,
forming a spacer layer on a peripheral surface of the upper portion of the first pillar section and on a peripheral surface of the lower portion of the third pillar section, and
forming a gate stack embedding the second pillar section and said upper portion and said lower portion, wherein the spacer layer forms a spacer between the gate stack and said upper portion and between the gate stack and said lower portion.

The inventive method enables a gate to be aligned vertically, in an accurate manner, with respect to the second pillar section. The spacer layer forms a spacer between, i.e. separating the gate stack from, the upper portion of the first pillar section and the lower portion of the third pillar section. An effective gate length may thereby be given by the vertical distance between the spacer portion on the upper portion of the first pillar section and the spacer portion on the lower portion of the third pillar section. Accordingly, an active channel region may be formed in the second pillar section. The vertical extension of the active channel region corresponds to the effective gate length.

Since the gate stack embeds not only the second pillar section but also the upper and lower portions of the first and third pillar sections, respectively, the effective gate length, and the vertical position of the effective gate, will not be influenced appreciably by the vertical position of the gate stack along the pillar. Gate stack misalignment could otherwise adversely impact device characteristics.

As the second pillar section is formed of a material being different from a material forming the upper portion of the first pillar section and different from a material forming the lower portion of the third pillar section, selective or at least preferential forming of the spacer layer on the upper and lower portions is enabled.

According to some embodiments, the spacer layer may be selectively formed on the peripheral surface of the upper portion of the first pillar section and on the peripheral surface of the lower portion of the third pillar section, but not on the second pillar section. In other words, the spacer layer may be formed to cover the peripheral surface of the upper and the lower portion of the first and the third pillar section, respectively, and to expose the second pillar section. According to some embodiments, the spacer layer may be preferentially formed on the peripheral surface of the upper portion of the first pillar section and on the peripheral surface of the lower portion of the third pillar section, and to a lesser extent on a peripheral surface of the second pillar section. In other words, the spacer layer may be formed with a greater thickness on the peripheral surface of the upper and the lower portion of the first and the third pillar section, respectively, and a smaller thickness on the peripheral surface of the second pillar section. Various advantageous embodiments for forming the spacer layer will be disclosed below.

As used herein, a "peripheral surface" of a pillar section may be used to refer to an exposed peripheral surface.

As used herein, the term "vertical" (e.g. with reference to an extension, a direction or a plane) denotes an extension/direction/plane being perpendicular to (a main plane of extension or main surface of) the substrate. The terms "above", "upper", "top" and "below", "lower", "bottom" refer to relative positions along the vertical direction. The term "horizontal" (e.g. with reference to an extension, a direction or a plane) denotes an extension/direction/plane being parallel to (a main plane of extension or main surface of) the substrate.

By vertical channel device is hereby meant a device, preferably a transistor, having a channel oriented vertically with respect to the substrate. An orientation of the channel may here refer to the direction of the flow of charge carriers through the channel, during use of the device.

Since the gate stack is formed to embed (i.e. completely surround or enclose) the second pillar section and the upper and the lower portion of the first and the third pillar section, respectively (i.e. in a circumferential direction with respect to the pillar) the device may be provided with a gate-all-around or wrap-around gate.

The upper portion of the first pillar section may refer to an upper thickness portion of the first pillar section. The second pillar section may be formed on and in contact with the upper portion of the first pillar section.

The lower portion of the third pillar section may refer to a lower thickness portion of the third pillar section. The lower portion of the third pillar section may be formed on and in contact with the second pillar section.

Both the upper portion and a lower portion of the first pillar section (or the entire first pillar section) may be formed of same material wherein the spacer layer may cover a peripheral surface of both the upper and the lower portion of the first pillar section. Additionally or alternatively, both the lower portion and an upper portion of the third pillar section (or the entire third pillar section) may be formed of same material wherein the spacer layer may cover a peripheral surface of both the lower and the upper portion of the third pillar section.

Alternatively, the first pillar section may include at least a first lower portion formed below said upper portion of the first pillar section, said first lower portion of the first pillar section being formed of a different material than said upper portion of the first pillar section.

The third pillar section may include at least a first upper portion formed above said lower portion of the third pillar section, said first upper portion of the third pillar section being formed of a different material than said lower portion of the third pillar section.

Hence, the lower and upper pillar sections may be formed as respective multi-layer sections. This provides improved design and process flexibility. This may also allow forming of a doped lower portion of the first pillar section and/or a doped upper portion of the third pillar section, for improved source/drain contacting.

The first pillar section may further include at least a second lower portion formed below the first lower portion of the first pillar section. The first pillar section may further include at least a second upper portion formed above the first upper portion of the third pillar section.

Depending on the material forming the lower portion(s) of the first pillar section and the material forming the upper portion(s) of the third pillar section, the spacer layer may or may not be formed on the lower portion(s) of the first pillar section and the upper portion(s) of the third pillar section.

According to one embodiment, the spacer layer is formed by an oxide layer. The spacer layer may accordingly be conveniently formed using an oxidation process. A thickness of the spacer layer thus formed may be controlled by means of the duration of the oxidation process.

According to one embodiment, the second pillar section is formed by a material presenting a lower oxidation rate than the material forming said upper portion and the material forming said lower portion and the method further comprises subjecting the pillar to an oxidation process, thereby forming an oxide layer on said peripheral surfaces and on a peripheral surface of the second pillar section, wherein oxide layer portions formed, by the oxidation process, on said upper and lower portions are formed with a greater thickness than an oxide layer portion formed on the second pillar section. This enables forming of a comparably thick oxide layer on the upper and the lower portion of the first and the third pillar section, respectively, and a comparably thin oxide layer on the second pillar section. As may be appreciated, the thickness variation of the oxide layer allows a greater separation to the gate conductor to be achieved at the upper and lower portions.

The oxidation process may include subjecting the pillar to a thermal treatment process. The oxidation may accordingly be conveniently controlled by means of the duration of the oxidation process and the temperature.

The method may further comprise reducing a thickness of the oxide layer. In other words, the thickness of the oxide layer portions on the upper portion of the first pillar section, on the second pillar section and on the lower portion of the third pillar section, respectively, may be reduced. This enables the oxide thickness on the second pillar section to be reduced as desired.

The thickness reduction of the oxide layer may form a final step of the forming of the spacer layer. Partially removing the oxide layer portion formed on the second pillar section enables the spacer layer to be formed preferentially on the lower and upper portions. The remaining reduced-thickness oxide portion on the upper portion of the first pillar section and the remaining reduced-thickness oxide portion on the lower portion of the third pillar section form respective portions of the spacer. Following forming of the gate stack, the remaining oxide portion on the upper portion of the first pillar section forms a spacer portion separating the gate stack from the upper portion. Correspondingly, the remaining oxide portion on the lower portion of the third pillar section forms a spacer portion separating the gate stack from the lower portion.

The thickness reduction may be adapted to cause a uniform reduction of the thickness of the oxide layer (i.e. the oxide layer portions).

The thickness reduction may be performed by subjecting the pillar to an oxide etch process.

The thickness of the oxide layer may be reduced such that the oxide layer portion formed on the second pillar section is removed (i.e. such that the peripheral surface of the second pillar section is exposed) and oxide layer portions of reduced thickness remain on the upper and the lower portion of the first and the third pillar section, respectively. This embodiment may be advantageous if it is undesired to include the oxide layer portion on the second pillar section in the gate dielectric of the gate stack.

The thickness reduction of the oxide layer may form a final step of the forming of the spacer layer. Removing the oxide layer portion formed on the second pillar section enables the spacer layer to be formed selectively on the lower and upper portions. The remaining reduced-thickness oxide portion on the upper portion and the remaining reduced-thickness oxide portion on the lower portion form respective portions of the spacer. Following forming of the gate stack, the remaining oxide portion on the upper portion of the first pillar section forms a spacer portion separating the gate stack from the upper portion. Correspondingly, the remaining oxide portion on the lower portion of the third pillar section forms a spacer portion separating the gate stack from the lower portion.

According to one embodiment, the second pillar section is formed by a first semiconductor species, and wherein said upper and lower portions are formed by an alloy of the first semiconductor species and at least a second semiconductor species. By forming the lower and upper portions of a semiconductor alloy, oxidation properties may be tailored by introducing an amount of second semiconductor species.

Advantageously, the upper and the lower portion may be formed by SiGe and the second pillar section may be formed by Si. SiGe presents a considerably greater oxidation rate than Si. Moreover, Si and SiGe may be etched from each other in a highly selective manner which may facilitate among others a selective thinning of the second pillar section, as will be disclosed below. By an oxidation process, oxide layer portions including germanium oxide may be formed on the upper and the lower portion. An oxide layer portion including silicon oxide may be formed on the second pillar section.

According to one embodiment, the method further comprises, forming a bottom insulating layer embedding the first pillar section and exposing said upper portion of the first pillar section, wherein the gate stack is formed on the bottom insulating layer. The gate stack may hence be separated and insulated from a bottom electrode or bottom source/drain region of the vertical channel device.

The bottom insulating layer may advantageously be formed prior to forming the spacer layer wherein a lower portion of the first pillar section, as well as a bottom electrode or bottom source/drain region of the vertical channel device, may be masked from the processing associated with the forming of the spacer layer (e.g. an oxidation process and oxide etching process).

According to one embodiment the method further comprises, prior to forming the gate stack, reducing a cross-sectional dimension of the second pillar section by etching the second pillar section selectively to said upper and lower portions. By "thinning" the second pillar section an improved channel control may be obtained. The thinning is advantageously performed prior to forming the spacer layer. The afore-mentioned bottom insulating layer may (if formed) advantageously be formed prior to the thinning, as a lower portion of the first pillar section thereby may be masked during the etching of the second pillar section.

According to one embodiment forming the gate stack includes forming a gate dielectric layer on the second pillar section and forming at least a first conductive layer on the gate dielectric layer. Preferably, the gate dielectric layer is formed by one or more high-k dielectric materials. The gate conductor may be a single conductive material or a compound conductive material including two or more conductive layers of different material.

According to one embodiment the method further comprises:
subsequent to forming the spacer layer and prior to forming the gate stack, forming a dummy gate embedding the second pillar section and said upper and lower portions,
depositing a fill layer embedding the dummy gate, and
removing the dummy gate, thereby forming a hole in the fill layer,
wherein the gate stack subsequently is formed in the hole. The gate stack may accordingly be formed in a manner corresponding to a replacement metal gate process.

According to an alternative embodiment forming the gate stack includes:
forming at least a first conductive layer embedding the second pillar section and said upper and lower portions, and
patterning said at least first conductive layer. The gate conductor may be a single conductive material or a compound conductive material including two or more conductive layers of different material.

According to a second aspect there is provided a vertical channel device comprising:
a substrate,
a vertical semiconductor pillar extending from the substrate and including a first pillar section, a second pillar section and a third pillar section, wherein the second pillar section is arranged between the first pillar section and the third pillar section and wherein the second pillar section is formed of a material being different material from a material forming an upper portion of the first pillar section and a material forming a lower portion of the third pillar section,
a spacer layer arranged on a peripheral surface of the upper portion of the first pillar section and on a peripheral surface of the lower portion of the third pillar section, and
a gate stack embedding the second pillar section and said upper portion and said lower portion, wherein the spacer layer forms a spacer between the gate stack and said upper portion and the gate stack and said lower portion.

As may be understood from the above discussion concerning the first method aspect, the device of the second aspect may be formed with an accurately controlled effective gate length and gate position, owing to the spacer layer forming the spacer between the gate stack and the upper portion and the gate stack and the lower portion.

According to one embodiment, the spacer layer is formed by an oxide layer. The spacer layer may accordingly be conveniently formed using an oxidation process. A thickness of the spacer layer thus formed may be controlled by means of the duration of the oxidation process.

According to one embodiment the second pillar section is formed by a material presenting a lower oxidation rate than the material forming said upper portion and the material forming said lower portion. This enables selective or preferential forming of the spacer layer on the upper and the lower portion of the first and third pillar section, respectively, by a process including an oxidation process.

According to one embodiment, the second pillar section includes a first semiconductor species, and wherein said upper and lower portions includes an alloy of the first semiconductor species and at least a second semiconductor species. By the lower and upper portions including a semiconductor alloy, oxidation properties may be tailored by introducing an amount of second semiconductor species.

Advantageously, the upper and the lower portion may be formed by SiGe and the second pillar section may be formed by Si. SiGe presents a considerably greater oxidation rate than Si.

According to one embodiment, the device further comprises a bottom insulating layer embedding the first pillar section and exposing said upper portion of the first pillar section, wherein the gate stack is formed on the bottom insulating layer. The gate stack may hence be separated and insulated from a bottom electrode or bottom source/drain region of the vertical channel device.

According to one embodiment a cross-sectional dimension of the second pillar section is smaller than a cross-sectional dimension of the first and the third pillar section. A "thinned" second pillar section enables an improved channel control.

In addition to the above, also the further description of advantages, details and embodiments of the first aspect apply correspondingly to the second aspect.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figures 1A-G illustrate a method for forming a vertical channel device.
Figure 2 illustrates a variation of a method for forming a vertical channel device.
Figures 3A-B illustrate a process for forming the gate stack.
Figures 4A-B illustrate a variation of a method for forming a vertical channel device using an alternative layer stack.

### Detailed description

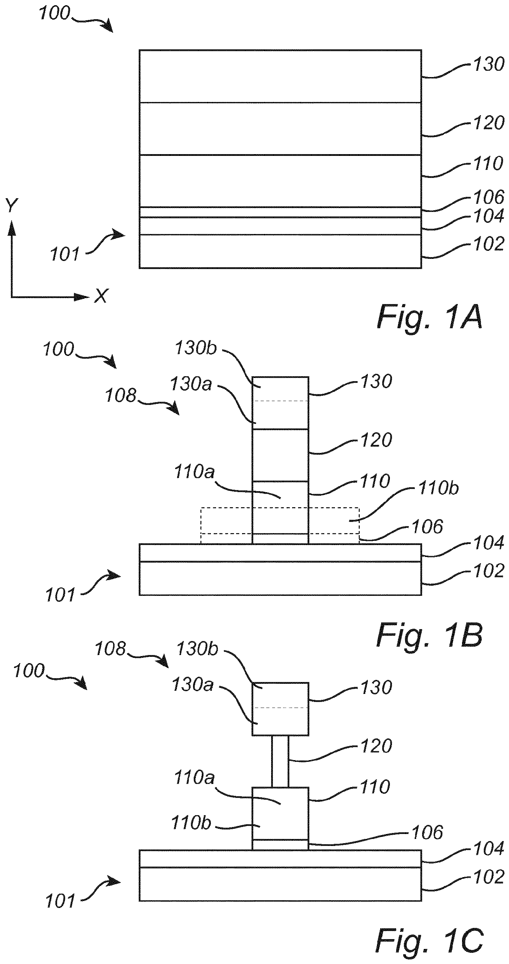

A method for forming a vertical channel device will now be described with reference to figures 1A-G.

Figure 1A shows a cross-sectional side view of a portion of a structure in the form of a layer stack. The layer stack may extend laterally or horizontally beyond the illustrated portion. Although in the following, forming of a single vertical channel device will be described and illustrated it should be noted that a plurality of such devices may be formed in parallel. It should be noted that the relative dimensions of the shown elements, in particular the relative thickness of the layers, is merely schematic and may, for the purpose of illustrational clarity, differ from a physical structure. Figure 1A includes an indication of a horizontal direction X, parallel to the main plane of extension of the layers, and a vertical direction Y, normal to the main plane of extensions of the layers.

The layer stack includes a substrate 101. The substrate 101 is of a silicon-on-insulator (SOI) type and includes a bottom layer 102. The bottom layer 102 may be formed of silicon (Si) or another semiconductor. An insulating layer 104, such as a buried-oxide layer, is formed on the bottom layer 102. An upper layer 106 of Si is formed on the insulating layer 104. The upper layer 106 may be an epitaxially grown layer. The upper layer 106 may be implanted with an appropriate dopant to reduce a resistance of the final device.

Although in the following, the substrate 101 described is of a SOI-type, it should be noted that also other types of substrates are possible. The substrate 101 may, depending on the materials of the further layers of the layer stack, for instance be a Si substrate, a germanium (Ge) substrate, a silicon-germanium (SiGe) substrate, a silicon-carbide (SiC) substrate, a Ge on insulator (GeOI) substrate or a SiGeOI substrate to name a few examples.

The layer stack includes a first layer 110, a second layer 120 formed on and in contact with the first layer 110, and a third layer 130 formed on and in contact with the second layer 120. The first layer 110 and the third layer 130 are formed of SiGe. The second layer 120 is formed of Si. The amount of Ge in the first layer 110 and the third layer 130 may be in the range of 10-90 %, preferably about 25 %. Each one of the first layer 110, the second layer 120 and the third layer 130 may be epitaxially grown layers. The method is applicable for forming a junction less type of device as well as an inversion mode type of device and the layers 110, 120, 130 may be doped accordingly. The layers 110, 120, 130 may be doped in a respective implantation step following completed growth of each one of the layers 110, 120, 130, or through doping diffusion from a heavily doped oxide layer. Alternatively, the layers 110, 120, 130 may be doped in-situ during their respective growth process.

In figure 1B a vertical semiconductor pillar 108 has been formed. The pillar 108 includes a first pillar section formed of a remaining portion of the first layer 110, a second pillar section formed of a remaining portion of the second layer 120 and a third pillar section formed of a remaining portion of the third layer 130. For simplicity the reference signs of the first through third layers will be used also for the corresponding layers first through third pillar sections.

The second pillar section 120 is formed on and in contact with the first pillar section 110. The third pillar section 130 is formed on and in contact with the second pillar section 120. The second pillar section 120 is arranged between the first pillar section 110 and the third pillar section 130. The first pillar section 110 and the third pillar section 130 are formed of SiGe. The second pillar section 120 is formed of Si, and hence of a different material than the first pillar section 110 and the third pillar section 130. The first pillar section 110 includes an upper portion 110a and a lower portion 110b. The third pillar section 130 correspondingly includes a lower portion 130a and an upper portion 130b.

The pillar 108 may be formed by patterning the layer stack shown in figure 1B. The pillar 108 may be patterned to present a circular or oval cross-sectional shape and thus form a column-like structure. However, the pillar 108 may also be patterned to present a rectangular or generally polygonal cross-sectional shape. The patterning may include forming of a patterned mask layer above the layer stack. Subsequently the pattern in the mask layer may be transferred into the layer stack by etching the layer stack while using the patterned mask layer as an etch mask. The mask layer may be a photoresist layer wherein the mask layer may be patterned in a lithographic process. Alternatively, a non-photoresist type of mask may be used, such as a hard mask, a spin-on-carbon mask or some other patterning film known to the skilled person. A pattern may be formed in the mask layer using a single litho-etch process, or using a multiple patterning process such as a multi litho-etch process. The pattern in the mask layer may subsequently be transferred into the layer stack by etching. Following the patterning of the layer stack any remaining portions of the mask layer may be removed.

As indicated by the full lines in figure 1B, the patterning may include transferring the mask pattern through the entire thickness of the first layer 110. The mask pattern may also be transferred into the upper layer 106. Alternatively, the mask pattern may be transferred only partially into the first layer 110 wherein a first pillar section 110 may be formed with a lower portion 110b and an upper portion 110a, the lower portion 110b having a greater lateral dimension than the upper portion 110a. In this case, the lower portion 110b and the upper layer 106 are preferably patterned to form a bottom region below the pillar which is physical and electrically separated from bottom regions of adjacent pillars. This is schematically shown by the dashed lines in figure 1B.

In figure 1C the pillar 108 has been subjected to an optional thinning step wherein a cross-sectional dimension of the second pillar section 120 has been reduced. A wet or dry etching process tuned for selectivity with respect to the Si of the second pillar section 120 has been performed to etch the second pillar section 120 selectively to the first pillar section 110 and the third pillar section 130.

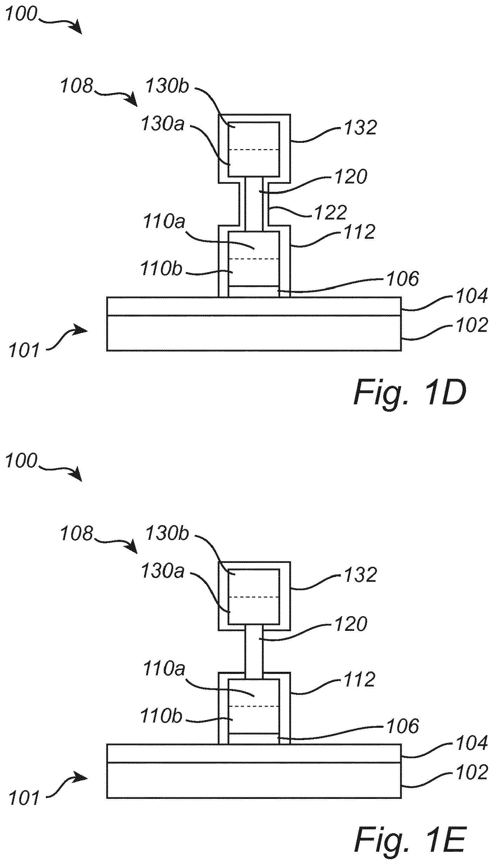

Figure 1D-E illustrate formation of a spacer layer 112, 132 in the form of an oxide layer on the first pillar section 110 and the third pillar section 130.

In figure 1D, the pillar 108 has been subjected to an oxidation process. The oxidation process may be a thermal treatment process including annealing the pillar 108 in for instance an oxygen atmosphere. By controlling the temperature and the atmosphere the oxidation rate may be controlled. By the oxidation process, an oxide layer is formed on the exposed peripheral surfaces of the pillar 108. A first oxide layer portion 112 is formed on the peripheral surface of the first pillar section 110. A second oxide layer portion 122 is formed on the peripheral surface of the second pillar section 120. A third oxide layer portion 132 is formed on the peripheral surface of the third pillar section 130. SiGe presents a greater rate of oxidation than Si. Consequently, as the first and the third pillar sections 110, 130 are formed of SiGe and the second pillar section 120 is formed of Si, the oxide layer portions 112, 132 formed on the first and the third pillar sections 110, 130 are formed with a greater thickness than the oxide layer portion 122 formed on the second pillar section 120. As shown, oxide may also form on sidewalls of the upper Si layer 106.

The first oxide layer portion 112 and the third oxide layer portion 132 may be formed of a germanium oxide. The second oxide layer portion 122 may be formed of silicon oxide. More generally, it may however understood that the type of oxide being formed on a respective pillar section depends on the material of the pillar section.

A thickness of the first and third oxide layer portions 112, 132 may be on the order of a few nanometers or more. For example, the thickness of the first and third oxide layer portions 112, 132 may be in the range of 1-20 nm. A thickness of the second oxide layer portion 122 may in any case be smaller than the thickness of the first and third oxide layer portions 112, 132.

Due to the preceding optional thinning step, the first pillar section 110 presents, in addition to vertically oriented and outwardly facing peripheral surface portion, a peripheral surface portion facing towards the third pillar section 130. Correspondingly, the third pillar section 130 presents, in addition to vertically oriented and outwardly facing peripheral surface portion, a peripheral surface portion facing towards the first pillar section 110. Oxide layer portions 110, 130 may hence be formed also on those horizontally oriented surface portions, as indicated in figure 1D.

In figure 1E, the thickness of the oxide layer has been reduced such that the second oxide layer portion 122 is removed and the first and the third oxide layer portion 112, 132 remain on the first and the third pillar sections 110, 130 with a reduced thickness. The peripheral surface of the second pillar section 120 is thus exposed. The thickness reduction may be performed by subjecting the pillar 108 to an isotropic oxide etch process, preferably a plasma-enhanced dry etching process. An isotropic oxide etch process may cause a reduction of thickness of the oxide layer portions 112, 122, 132. Depending on the tuning of the etch process, the etch rate of the oxide layer portion 122 may be greater than the etch rate of the oxide layer portions 112, 132. However, a uniform etch rate is also possible. The etching may be stopped when the second pillar section 120 is exposed. Due to their greater initial thickness, reduced thickness first and third oxide layer portions 112, 132 may then remain on the first and third pillar sections 110, 130. A selectively formed spacer layer 112, 132, covering the peripheral surfaces of the first and the third pillar sections 110, 130 but exposing the second pillar section 120 has accordingly been obtained. Although not shown in figure 1E, a corresponding thinning of also oxide layer portions on the sidewalls of the upper Si layer 106 may also result.

It should be noted that the thickness reduction need not result in a complete removal of the second oxide layer portion 122. Rather the thickness reduction may be stopped when a sufficiently thin second oxide layer portion 122 still remains. Indeed, it may not even be needed to perform any thickness reduction at all provided the oxidation process results in forming of a sufficiently thin second oxide layer portion 122. By sufficiently thin is hereby meant a thickness such that the second oxide layer portion 122 may be included in a gate stack 150 of the device without unacceptable loss of device performance.

As both the upper and the lower portion 110a, 110b of the first pillar section 110, and the lower and the upper portion 130a, 130b of the third pillar section 130 are formed of SiGe, the spacer layer 112, 132 will form on the peripheral surfaces along the entire first and third pillar sections 110, 130. This corresponds to the configuration shown in figures 1D-E. However, in case the pillar includes first and third pillar sections with multi-layered configurations, this need not be the case. As will be further described below, the spacer layer may, depending on the composition of the first and the third pillar section, cover the entire peripheral surfaces thereof, or only portions of the peripheral surfaces thereof. In any case, the spacer layer should however be formed to cover the peripheral surface portion of at least the upper portion of the first pillar section and the peripheral surface portion of at least the lower portion of the third pillar section.

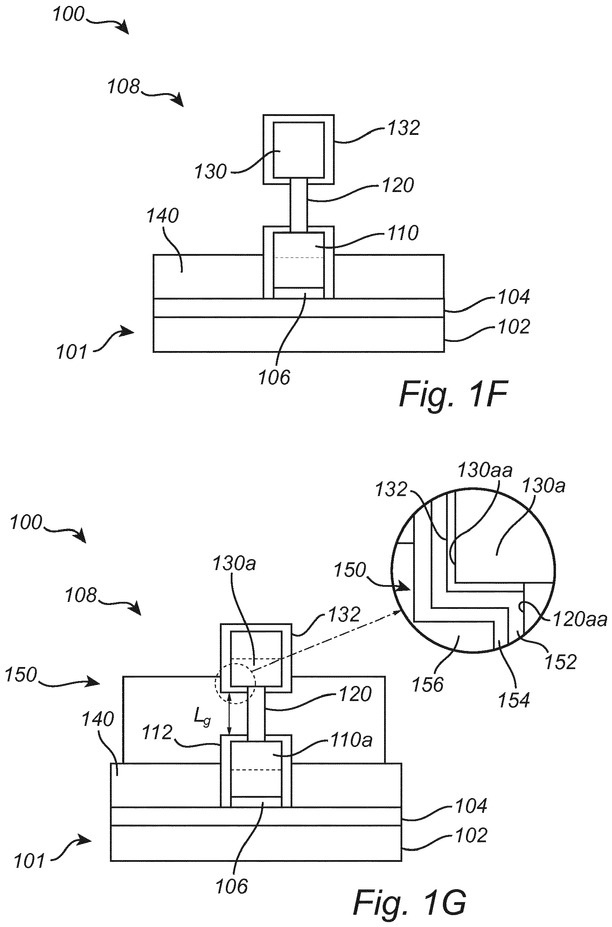

In figure 1F, a bottom insulating layer 140 has been formed on the substrate 101. The bottom insulating layer 140 embeds the first pillar section 110 and is formed with a thickness such that the upper portion 110a of the first pillar section 110 is exposed. The bottom insulating layer 140 may be formed by a dielectric material such as a silicon oxide material, for instance SiO₂ or SiN or some other conventional dielectric material. Provided the material forming the bottom insulating layer 140 is formed of a different material than the spacer layer 112, 132, the bottom insulating layer 140 may be deposited by any conventional deposition process, such as chemical vapor deposition (CVD), and subsequently etched back selectively with respect to the spacer layer 112, 132 until a layer 140 with a desired thickness has been obtained.

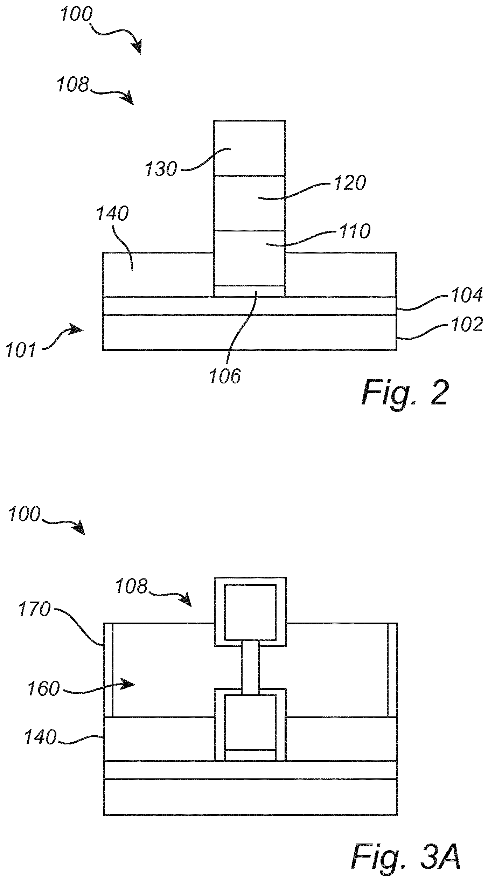

According to an alternative scheme illustrated in figure 2, a bottom insulating layer 140 may be formed (for instance by CVD) prior to the method step shown in figure 1D, or already prior to the method step shown in figure 1C.

In figure 1G, a gate stack 150 has been formed around the pillar 108. The gate stack 150 is formed on the bottom insulating layer 140. The gate stack 150 embeds the second pillar section 120 as well as the upper portion 110a of the first pillar section 110 and the lower portion 130a of the third pillar section 130. The spacer layer, more specifically the spacer layer portions 112, 132, forms a spacer between the gate stack 150 and the upper portion 110a and between the gate stack 150 and the lower portion 130a, respectively.

As schematically shown in the enlarged partial view in figure 1G, the gate stack 150 is formed to include a gate dielectric layer 152 on the peripheral surface 120aa of the second pillar section 120. The gate dielectric layer 152 may be formed by any conventional gate dielectric material such as HfO₂, ZrO₂, Al₂O₃ or some other high-K dielectric material. The gate dielectric layer 150 may be formed by one layer of a dielectric material or by a stack of different dielectric materials. The gate dielectric layer 152 may be deposited as a conformal thin film by any conventional deposition process, for instance by atomic layer deposition (ALD). An interfacial layer, such as an interfacial oxide layer of for instance SiO₂, may be formed on the peripheral surface 120aa of the second pillar section 120 prior to providing the gate dielectric layer 150.

A gate conductor including at least a first conductive layer 154 may subsequently be formed on the gate dielectric layer 152. The first conductive layer 154 may be formed by an effective work function metal (EWF). The first conductive layer 154 may for instance be formed by one or more p-type EWF metals such as TiN, TaN, TiTaN or by one or more n-type EWF metals such as Al, TiAl, TiC, or TiAlC, or compound layers such as TiN/TiAl or TiN/TaN/TiAl. The first conductive layer 154 may be deposited by any conventional deposition process, for instance by ALD, CVD or tilted physical vapor deposition (PVD).

The gate conductor may further include a second conductive layer 156, for instance of W, Al, Co, Ni, Ru or an alloy of two or more of said materials, to provide a gate conductor with the desired electrical properties. The second conductive layer 156 may be deposited by any conventional deposition process, for instance by CVD or by electro-plating.

As may be seen in the enlarged partial view in figure 1G, the spacer layer portion 132 on the peripheral surface 130aa of the third pillar section 130 forms a spacer between the gate stack 150 and the third pillar section 130. The spacer hence physically and electrically separates the gate stack 150, in particular the gate conductor thereof, from the third pillar section 130. Forming the spacer layer portion 132 with a sufficient thickness, enables the spacer to minimize an electrical field generated by the gate stack 150 within the third pillar section 130, during use of the device. Hence the gate stack 150 may not exert any direct appreciable control of the conduction within third pillar section 130. Although not shown, this applies correspondingly to the presence of the spacer layer portion 112 on the first pillar section 110.

An extension of the active channel region may hence be accurately controlled during device fabrication to be confined to the second pillar section 120. As may be appreciated, an effective gate length (denoted Lg in figure 1 G) may not exceed the minimum vertical distance between the spacer portion 112 on the upper portion 110a of the first pillar section 110 and the spacer portion 132 on the lower portion 130a of the third pillar section 130. The first pillar section 110 may accordingly form a first source/drain region of the device. The third pillar section 130 may form a third source/drain region of the device.

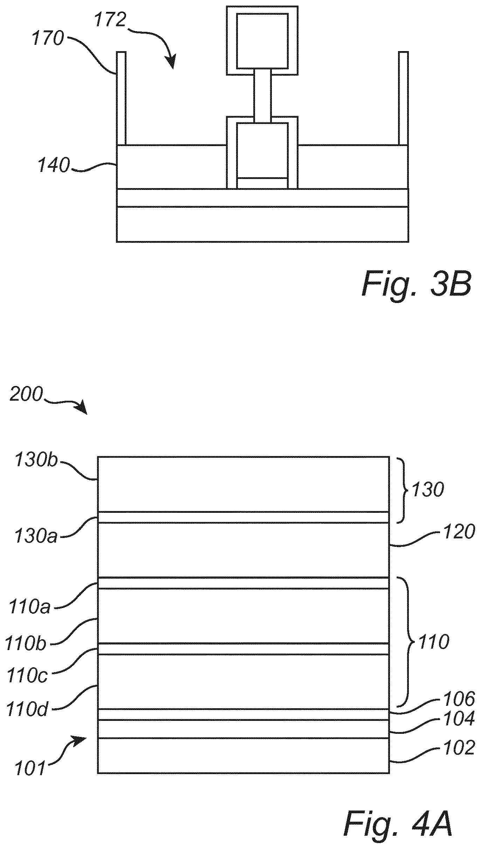

The above described method is compatible with a replacement gate (RMG) process as schematically shown in figures 3A-B. Subsequent to forming the spacer layer 112, 132 and prior to forming the gate stack 150, a dummy gate 160 is formed. The dummy gate 160 may be formed by depositing a dummy gate layer (for instance of polysilicon or a combination of amorphous silicon and a dummy SiO₂ layer below) embedding the pillar 108 at least up to the level of the lower portion 130a of the third pillar section 130. The dummy gate layer may subsequently be patterned such that a dummy gate 160 with the desired lateral dimensions is obtained. Dummy gate patterning is per se a process known to the skilled person and will therefore not be further described herein. Subsequent to forming the dummy gate 160, a fill layer 170 is deposited to embed the dummy gate 160. The fill layer 170 may be formed by any appropriate material used in conventional RMG processes (such as an oxide- or nitride-based material), provided the material is selected to be different from the material of the dummy gate 160 and of the spacer layer 112, 132. As shown in figure 3B a hole 172 is then formed by removing the dummy gate 160 selectively to the fill layer 170. The gate stack 150 may subsequently be formed in the hole 172.

As an alternative to a RMG-type of process, the gate stack 150 may be formed by forming the gate dielectric layer 152, performing a blanket deposition of the gate conductor (including at least the first conductive layer 154), and subsequently patterning the gate stack conductor to obtain a gate stack 150 with desired lateral dimensions using any suitable etching chemistries for the various above-mentioned gate conductor materials.

Subsequent to the stage of the method shown in figure 1G, further device processing may be performed including forming source/drain contacts, and eventually conventional back-end-of-line processing to form routing layers incorporating the vertical channel devices in functioning circuitry.

In the above, a method was described in connection with a pillar 108 having a SiGe/Si/SiGe layer configuration. It is however contemplated that also other combinations semiconductor materials may be. For instance, the second pillar section 120 may be formed by a first semiconductor species, and the first and the third pillar sections 110, 130 may be formed by different SiₓGe₁₋ₓ alloys. Provided the spacer layer is formed in an oxidation process, it may be understood that the resulting type of oxide will depend on the composition of the pillar sections 110, 120, 130.

It is also possible to form a spacer layer on the first and third pillar sections by other means than an oxidation process, such as a dielectric spacer layer, for instance by deposition and etch of a dielectric sidewall spacer, or a selective deposition of a dielectric sidewall spacer on the first and third pillar sections.

Figures 4A-B illustrate an alternative composition of a layer stack 200 which may be used for forming a vertical channel device.

The layer stack 200 differs from the layer stack 100 shown in figure 1A in that the first pillar section 110 is formed to includes at least a first lower portion 110b formed below the upper portion 110a of the first pillar section 110, the first lower portion 110b being formed of a different material than the upper portion 110a. As described above, the upper portion 110a may be formed by SiGe. The lower portion 110 may be formed by Si. As shown, the first pillar section 100 may be formed to include further lower portions, such as a second lower portion 110c and a third lower portion 110d. The second lower portion 110c may be formed of a same material as the upper portion 110a. The third lower portion 110d may be formed of a same material as the first lower portion 110b. The third pillar section 130 may be formed in a corresponding manner to include at least a first upper portion 130b formed above the lower portion 130a, the first upper portion 130b being formed of a different material (e.g. Si) the lower portion 130a (e.g. SiGe). The further lower portions 110b, 110c, 110d and the further upper portions 130b may be formed with a composition and/or doped to tailor the electrical device properties, for instance for the purpose of enabling improved source and drain contacting.

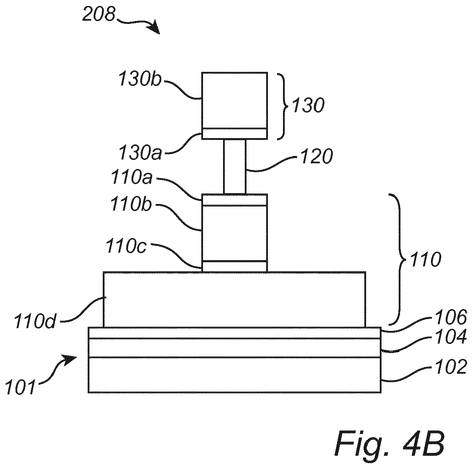

When subjecting any Si-portions of the first and third pillar sections 110 to the process steps, they may be affected in a similar manner as the second pillar section 120 as described in connection with figures 1A-G, provided the portions are not masked from the process steps (for instance by a bottom insulating layer, not shown in figure 4B). Correspondingly, any SiGe-portions of the first and third pillar sections 110, may be affected in a similar manner as the upper and the lower portions 110a, 130a as described in connection with figures 1A-G, provided the portions are not masked from the process steps (for instance by a bottom insulating layer, not shown in figure 4B).

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a vertical channel device, the method comprising:
forming on a substrate (101) a vertical semiconductor pillar (108) including a first pillar section (110), a second pillar section (120) and a third pillar section (130), wherein the second pillar section (120) is arranged between the first pillar section (110) and the third pillar section (130) and wherein the second pillar section (120) is formed of a material being different from a material forming an upper portion (110a) of the first pillar section (110) and different from a material forming a lower portion (130a) of the third pillar section (130),
forming a spacer layer (112, 132) on a peripheral surface of the upper portion (110a) of the first pillar section (110) and on a peripheral surface (130aa) of the lower portion (130a) of the third pillar section (130), and
forming a gate stack (150) embedding the second pillar section (120) and said upper portion (110a) and said lower portion (130a), wherein the spacer layer (112, 132) forms a spacer between the gate stack (150) and said upper portion (110a) and between the gate stack (150) and said lower portion (130a).

2. A method according to claim 1, wherein the spacer layer (112, 132) is formed by an oxide layer.

3. A method according to any of the preceding claims, wherein the second pillar section (120) is formed by a material presenting a lower oxidation rate than the material forming said upper portion (110a) and the material forming said lower portion (130a), and the method further comprising subjecting the pillar (108) to an oxidation process, thereby forming an oxide layer on said peripheral surfaces (130aa) and on a peripheral surface of the second pillar section (120), wherein oxide layer portions (112, 132) formed on said upper and lower portions (110a, 130a) are formed with a greater thickness than an oxide layer portion (122) formed on the second pillar section (120).

4. A method according to claim 3, further comprising reducing a thickness of the oxide layer (112, 122, 132).

5. A method according to claim 4, wherein the thickness of the oxide layer (112, 122, 132) is reduced such that the oxide layer portion (122) formed on the second pillar section (120) is removed and oxide layer portions (112, 132) of reduced thickness remain on said upper and lower portions (110a, 130a).

6. A method according to any of the preceding claims, wherein the second pillar section (120) is formed by a first semiconductor species, and wherein said upper and lower portions (110a, 130a) are formed by an alloy of the first semiconductor species and at least a second semiconductor species.

7. A method according to any of the preceding claims, wherein said upper and lower portions (110a, 130a) are formed by SiGe and the second pillar section (120) is formed by Si.

8. A method according to any of the preceding claims,
wherein the first pillar section (110) includes at least a first lower portion (110b) formed below said upper portion (110a) of the first pillar section (110), said first lower portion (110b) of the first pillar section (110) being formed of a different material than said upper portion (110a) of the first pillar section (110), and
wherein the third pillar section (130) includes at least a first upper portion (130b) formed above said lower portion (130a) of the third pillar section (130), said first upper portion (130b) of the third pillar section (130) being formed of a different material than said lower portion (130a) of the third pillar section (130).

9. A method according to any of the preceding claims, further comprising, forming a bottom insulating layer (140) embedding the first pillar section (110) and exposing said upper portion (110a) of the first pillar section (110), wherein the gate stack (150) is formed on the bottom insulating layer (140).

10. A method according to any of the preceding claims, further comprising, prior to forming the gate stack (150), reducing a cross-sectional dimension of the second pillar section (120) by etching the second pillar section (120) selectively to said upper and lower portions (110a, 130a).

11. A method according to any of the preceding claims, wherein forming the gate stack includes forming a gate dielectric layer (152) on the second pillar section (120) and forming at least a first conductive layer (154) on the gate dielectric layer (152).

12. A method according to any of the preceding claims, further comprising:
subsequent to forming the spacer layer (112, 132) and prior to forming the gate stack (150), forming a dummy gate (160) embedding the second pillar section (120) and said upper and lower portions (110a, 130a),
depositing a fill layer (170) embedding the dummy gate (160), and
removing the dummy gate (160), thereby forming a hole (172) in the fill layer (170),
wherein the gate stack (150) subsequently is formed in the hole (172).

13. A method according to any of claims 1-11, wherein forming the gate stack (150) includes:
forming at least a first conductive layer (154) embedding the second pillar section (120) and said upper and lower portions (110a, 130a), and
patterning said at least first conductive layer (154).

14. A vertical channel device comprising:
a substrate (101),
a vertical semiconductor pillar extending from the substrate and including a first pillar section (110), a second pillar section (120) and a third pillar section (130), wherein the second pillar section (120) is arranged between the first pillar section (110) and the third pillar section (130) and wherein the second pillar section (120) is formed of a material being different material from a material forming an upper portion (110a) of the first pillar section (110) and a material forming a lower portion (130a) of the third pillar section (130),
a spacer layer (112, 132) arranged on a peripheral surface of the upper portion (110a) of the first pillar section (110) and on a peripheral surface (130aa) of the lower portion (130a) of the third pillar section (130), and
a gate stack (150) embedding the second pillar section (120) and said upper portion (110a) and said lower portion (130a), wherein the spacer layer (112, 132) forms a spacer between the gate stack (150) and said upper portion (110a) and the gate stack (150) and said lower portion (130a).

15. A device according to claim 14, wherein the second pillar section (120) is formed by a material presenting a lower oxidation rate than the material forming said upper portion (110a) and the material forming said lower portion (130a),
